# EUROPEAN PATENT APPLICATION

(11) **EP 3 285 173 A1**
(43) Date of publication of application: **21.02.2018**
(21) Application number: 16838241.4
(22) Date of filing: 14.03.2016
(51) Int. Cl.: G06F 15/16

(54) **CPU INTERCONNECTING APPARATUS, SYSTEM AND CONTROL METHOD, CONTROL APPARATUS THEREFOR**

(30) Priority: 25.08.2015 CN 201510526313
(71) Applicant: Huawei Technologies Co., Ltd., Longgang District Shenzhen, Guangdong 518129 (CN)
(72) Inventor: LIAO, Defu, Shenzhen Guangdong 518129 (CN)
(74) Representative: Kreuz, Georg Maria
(86) International application number: PCT/CN2016/076267
(87) International publication number: WO 2017/031978

(57) **Abstract**

The present invention pertains to the field of electronic technologies, and discloses a CPU interconnect apparatus and system, and a CPU interconnect control method and control apparatus. The CPU interconnect apparatus includes at least one switching circuit, where each switching circuit includes two gating units and one first intermediate line, each gating unit includes a first terminal and a second terminal, the first terminal is connected to the second terminal when the gating unit is in a first state, the first terminal is disconnected from the second terminal when the gating unit is in a second state, the two first terminals of each switching circuit are respectively configured to connect to two CPUs in a first node, and the two second terminals of each switching circuit are respectively connected to two ends of the first intermediate line, or the two second terminals of each switching circuit are respectively configured to connect to two CPUs in a second node.

## Description

This application claims priority to Chinese Patent Application No. 201510526313.5, filed with the Chinese Patent Office on August 25, 2015 and entitled "CPU INTERCONNECT APPARATUS AND SYSTEM, AND CPU INTERCONNECT CONTROL METHOD AND CONTROL APPARATUS", which is incorporated herein by reference in its entirety.

### TECHNICAL FIELD

The present invention relates to the field of electronic technologies, and in particular, to a CPU interconnect apparatus and system, and a CPU interconnect control method and control apparatus.

### BACKGROUND

In a Quick Path Interconnect (English: Quick Path Interconnect, QPI for short) technology, central processing units (English: Central Processing Unit, CPU for short) in multiple nodes are interconnected, so that the multiple nodes that originally work independently can be combined into an entity (that is, form a partition), and the entity formed by means of combination serves as an execution body to undertake original work of all the nodes. This increases a data bearing capacity and a processing capability of all the nodes.

In the prior art, a quantity of terminals of a CPU is limited, and in actual application, it is generally impossible to connect every CPU in a partition to other CPUs in a pairwise manner. Therefore, during topology creation, when a CPU is to be connected to other CPUs, the CPU is selectively connected to several CPUs in the other CPUs. Because there are multiple connection manners for connecting one CPU to several CPUs in other CPUs, for interconnection of CPUs in multiple nodes, multiple topology structures may be created according to different selected connection manners. However, after the creation is complete, the topology structures are fixed, and therefore, diversified requirements of a system cannot be met.

### SUMMARY

To resolve the problem in the prior art, embodiments of the present invention provide a CPU interconnect apparatus and system, and a CPU interconnect control method and control apparatus. The technical solutions are as follows:
According to a first aspect, an embodiment of the present invention provides a CPU interconnect apparatus, including at least one switching circuit, where each switching circuit includes two gating units and one first intermediate line, each gating unit includes a first terminal and a second terminal, the first terminal is connected to the second terminal when the gating unit is in a first state, the first terminal is disconnected from the second terminal when the gating unit is in a second state, the two first terminals of each switching circuit are respectively configured to connect to two CPUs in a first node, and the two second terminals of each switching circuit are respectively connected to two ends of the first intermediate line, or the two second terminals of each switching circuit are respectively configured to connect to two CPUs in a second node.

In an implementation manner of this embodiment of the present invention, the gating unit further includes a third terminal, the first terminal is disconnected from the third terminal when the gating unit is in the first state, the first terminal is connected to the third terminal when the gating unit is in the second state, the two second terminals of each switching circuit are respectively connected to the two ends of the first intermediate line, and the two third terminals of each switching circuit are respectively configured to connect to two CPUs in the second node.

In another implementation manner of this embodiment of the present invention, the apparatus includes a second intermediate line, and a third terminal of the switching circuit is connected by using the second intermediate line to a third terminal of a switching circuit to which a CPU in the second node is connected.

In another implementation manner of this embodiment of the present invention, a third terminal of the switching circuit is connected by using a processing unit in an NC to a third terminal of a switching circuit to which a CPU in the second node is connected.

In another implementation manner of this embodiment of the present invention, the gating unit is a switch circuit, an electronic switch, a gate, a selector, or an allocator.

According to a second aspect, an embodiment of the present invention provides a CPU interconnect system, including multiple nodes, where the multiple nodes include a first node and a second node, each node includes multiple directly-connected CPUs, and the CPU interconnect system further includes the CPU interconnect apparatus described above.

According to a third aspect, an embodiment of the present invention provides a CPU interconnect control method applicable to a CPU interconnect system, where the CPU interconnect system includes multiple nodes, the multiple nodes include a first node and a second node, each node includes multiple directly-connected CPUs, the CPU interconnect system further includes a CPU interconnect apparatus, the CPU interconnect apparatus includes at least one switching circuit, each switching circuit includes two gating units and one first intermediate line, each gating unit includes a first terminal and a second terminal, the two first terminals of each switching circuit are respectively configured to connect to two CPUs in the first node, and the two second terminals of each switching circuit are respectively connected to two ends of the first intermediate line, or the two second terminals of each switching circuit are respectively configured to connect to two CPUs in the second node, and the method includes:
obtaining a topology change indication signal;
determining a status of the gating unit according to the topology change indication signal, where the status includes a first state and a second state; and
when the status of the gating unit is the first state, controlling the first terminal of the gating unit to connect to the second terminal of the gating unit, and when the status of the gating unit is the second state, controlling the first terminal to disconnect from the second terminal.

In an implementation manner of this embodiment of the present invention, the gating unit further includes a third terminal, the two second terminals of each switching circuit are respectively connected to the two ends of the first intermediate line, the two third terminals of each switching circuit are respectively configured to connect to two CPUs in the second node, and the method further includes:
when the status of the gating unit is the first state, controlling the first terminal to disconnect from the third terminal, and when the status of the gating unit is the second state, controlling the first terminal to connect to the third terminal.

In another implementation manner of this embodiment of the present invention, the obtaining a topology change indication signal includes:
receiving the topology change indication signal entered by a user, where the topology change indication signal includes the topology change indication information, the topology change indication information includes a changed quantity of CPUs in a system partition or a changed system application scenario, and the system application scenario is an online analytical processing scenario or an online transaction processing scenario.

In another implementation manner of this embodiment of the present invention, the obtaining a topology change indication signal includes:
obtaining system monitoring information, where the system monitoring information includes at least one of CPU load or a CPU latency; and
generating the topology change indication signal according to the system monitoring information, where the topology change indication signal includes topology change indication information, and the topology change indication information includes at least one of a CPU with excessively high load or a CPU with an excessively long latency.

In another implementation manner of this embodiment of the present invention, the determining a status of the gating unit according to the topology change indication signal includes:
determining a changed topology of the CPU interconnect system according to the topology change indication signal; and
determining the status of the gating unit according to the changed topology of the CPU interconnect system.

In another implementation manner of this embodiment of the present invention, the determining a changed topology of the CPU interconnect system according to the topology change indication signal includes:
obtaining a correspondence between the topology change indication signal and a topology; and
determining the changed topology of the CPU interconnect system according to the correspondence between the topology change indication signal and a topology, where the changed topology of the CPU interconnect system corresponds to the topology change indication signal.

In another implementation manner of this embodiment of the present invention, the determining a changed topology of the CPU interconnect system according to the topology change indication signal includes:
determining a topology change according to the topology change indication signal, where the topology change includes that a line between two CPUs is connected or that a line between two CPUs is disconnected; and
determining the changed topology of the CPU interconnect system according to the topology change and a topology that is of the CPU interconnect system and is before a change.

In another implementation manner of this embodiment of the present invention, the determining a topology change according to the topology change indication signal includes:
when the topology change indication signal includes a CPU with excessively high load or a CPU with an excessively long latency, determining the CPU with excessively high load or with an excessively long latency; and
changing a connection between the determined CPU and a CPU in the second node to a connection between CPUs in the first node, where the determined CPU is located in the first node.

In another implementation manner of this embodiment of the present invention, the determining a changed topology of the CPU interconnect system includes:
determining connection sets C1, C2, and C3, where the connection set C1 includes a direct connection between two CPUs, the connection set C2 includes a first intermediate line, a second intermediate line, and a connection between a CPU and a gating unit or a connection between a CPU and a processing unit, and the connection set C3 includes a pseudo-direct connection, where the pseudo-direct connection is a connection established between two CPUs by using the first intermediate line or the second intermediate line.

In another implementation manner of this embodiment of the present invention, the determining the status of the gating unit according to the changed topology of the CPU interconnect system includes:
obtaining the connection sets C2 and C3 in the changed topology of the CPU interconnect system;
determining, according to the connection sets C2 and C3, a first intermediate line or a second intermediate line to which each gating unit is connected; and
determining the status of the gating according to the first intermediate line or the second intermediate line to which each gating unit is connected.

According to a fourth aspect, an embodiment of the present invention provides a CPU interconnect control apparatus applicable to a CPU interconnect system, where the CPU interconnect system includes multiple nodes, the multiple nodes include a first node and a second node, each node includes multiple directly-connected CPUs, the CPU interconnect system further includes a CPU interconnect apparatus, the CPU interconnect apparatus includes at least one switching circuit, each switching circuit includes two gating units and one first intermediate line, each gating unit includes a first terminal and a second terminal, the two first terminals of each switching circuit are respectively configured to connect to two CPUs in the first node, and the two second terminals of each switching circuit are respectively connected to two ends of the first intermediate line, or the two second terminals of each switching circuit are respectively configured to connect to two CPUs in the second node, and the apparatus includes:
an obtaining module, configured to obtain a topology change indication signal;
a determining module, configured to determine a status of the gating unit according to the topology change indication signal, where the status includes a first state and a second state; and
a control module, configured to: when the status of the gating unit is the first state, control the first terminal of the gating unit to connect to the second terminal of the gating unit, and when the status of the gating unit is the second state, control the first terminal to disconnect from the second terminal.

In an implementation manner of this embodiment of the present invention, the gating unit further includes a third terminal, the two second terminals of each switching circuit are respectively connected to the two ends of the first intermediate line, the two third terminals of each switching circuit are respectively configured to connect to two CPUs in the second node, and the control module is further configured to:
when the status of the gating unit is the first state, control the first terminal to disconnect from the third terminal, and when the status of the gating unit is the second state, control the first terminal to connect to the third terminal.

In another implementation manner of this embodiment of the present invention, the obtaining module is specifically configured to:
receive the topology change indication signal entered by a user, where the topology change indication signal includes the topology change indication information, the topology change indication information includes a changed quantity of CPUs in a system partition or a changed system application scenario, and the system application scenario is an online analytical processing scenario or an online transaction processing scenario.

In another implementation manner of this embodiment of the present invention, the obtaining module includes:
a first obtaining submodule, configured to obtain system monitoring information, where the system monitoring information includes at least one of CPU load or a CPU latency; and
a generation submodule, configured to generate the topology change indication signal according to the system monitoring information, where the topology change indication signal includes topology change indication information, and the topology change indication information includes at least one of a CPU with excessively high load or a CPU with an excessively long latency.

In another implementation manner of this embodiment of the present invention, the determining module includes:
a second obtaining submodule, configured to determine a changed topology of the CPU interconnect system according to the topology change indication signal; and
a first determining submodule, configured to determine the status of the gating unit according to the changed topology of the CPU interconnect system.

In another implementation manner of this embodiment of the present invention, the second obtaining submodule is specifically configured to:
obtain a correspondence between the topology change indication signal and a topology; and
determine the changed topology of the CPU interconnect system according to the correspondence between the topology change indication signal and a topology, where the changed topology of the CPU interconnect system corresponds to the topology change indication signal.

In another implementation manner of this embodiment of the present invention, the second obtaining submodule is specifically configured to:
determine a topology change according to the topology change indication signal, where the topology change includes that a line between two CPUs is connected or that a line between two CPUs is disconnected; and
determine the changed topology of the CPU interconnect system according to the topology change and a topology that is of the CPU interconnect system and is before a change.

In another implementation manner of this embodiment of the present invention, the second obtaining submodule is specifically configured to:
when the topology change indication signal includes a CPU with excessively high load or a CPU with an excessively long latency, determine the CPU with excessively high load or with an excessively long latency; and
change a connection between the determined CPU and a CPU in the second node to a connection between CPUs in the first node, where the determined CPU is located in the first node.

In another implementation manner of this embodiment of the present invention, the second obtaining submodule is specifically configured to:
determine connection sets C1, C2, and C3, where the connection set C1 includes a direct connection between two CPUs, the connection set C2 includes a first intermediate line, a second intermediate line, and a connection between a CPU and a gating unit or a connection between a CPU and a processing unit, and the connection set C3 includes a pseudo-direct connection, where the pseudo-direct connection is a connection established between two CPUs by using the first intermediate line or the second intermediate line.

In another implementation manner of this embodiment of the present invention, the first determining submodule is specifically configured to:
obtain the connection sets C2 and C3 in the changed topology of the CPU interconnect system;
determine, according to the connection sets C2 and C3, a first intermediate line or a second intermediate line to which each gating unit is connected; and
determine the status of the gating according to the first intermediate line or the second intermediate line to which each gating unit is connected.

The technical solutions provided in the embodiments of the present invention have the following advantageous effects:
When two gating units in a CPU interconnect apparatus are in a first state, first terminals are connected to second terminals, and the two second terminals are connected by using a first intermediate line, so that CPU interconnection is implemented in a first node. Alternatively, the two second terminals are respectively configured to connect to two CPUs in a second node, so that CPU interconnection is implemented between the first node and the second node. However, when the two gating units are in a second state, the first terminals are disconnected from the second terminals. Therefore, by switching between the first state and the second state, CPU interconnection and CPU disconnection of intra-node or inter-node can be implemented. Therefore, a topology of a CPU interconnect system meets different feature and scenario requirements, and processing performance of CPUs in the CPU interconnect system is improved.

### BRIEF DESCRIPTION OF DRAWINGS

To describe the technical solutions in the embodiments of the present invention more clearly, the following briefly describes the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1a is a schematic structural diagram of a CPU interconnect apparatus according to an embodiment of the present invention;
FIG. 1b is a schematic structural diagram of another CPU interconnect apparatus according to an embodiment of the present invention;
FIG. 1c is a schematic structural diagram of another CPU interconnect apparatus according to an embodiment of the present invention;
FIG. 2 is a schematic structural diagram of a CPU interconnect system according to an embodiment of the present invention;
FIG. 3a is a schematic structural diagram of a CPU interconnect system according to an embodiment of the present invention;
FIG. 3b is a schematic structural diagram of a CPU interconnect system according to an embodiment of the present invention;
FIG. 4 is a schematic structural diagram of another CPU interconnect system according to an embodiment of the present invention;
FIG. 5a is a schematic structural diagram of another CPU interconnect system according to an embodiment of the present invention;
FIG. 5b is a schematic structural diagram of another CPU interconnect system according to an embodiment of the present invention;
FIG. 6 is a flowchart of a CPU interconnect control method according to an embodiment of the present invention;
FIG. 7 is a flowchart of another CPU interconnect control method according to an embodiment of the present invention;
FIG. 8 is a topology structure diagram according to an embodiment of the present invention;
FIG. 9 is another topology structure diagram according to an embodiment of the present invention;
FIG. 10a is another topology structure diagram according to an embodiment of the present invention;
FIG. 10b is another topology structure diagram according to an embodiment of the present invention;
FIG. 11 is a schematic structural diagram of a CPU interconnect control apparatus according to an embodiment of the present invention; and
FIG. 12 is a schematic structural diagram of a CPU interconnect control apparatus according to an embodiment of the present invention.

### DESCRIPTION OF EMBODIMENTS

To make the objectives, technical solutions, and advantages of the present invention clearer, the following further describes the embodiments of the present invention in detail with reference to the accompanying drawings.

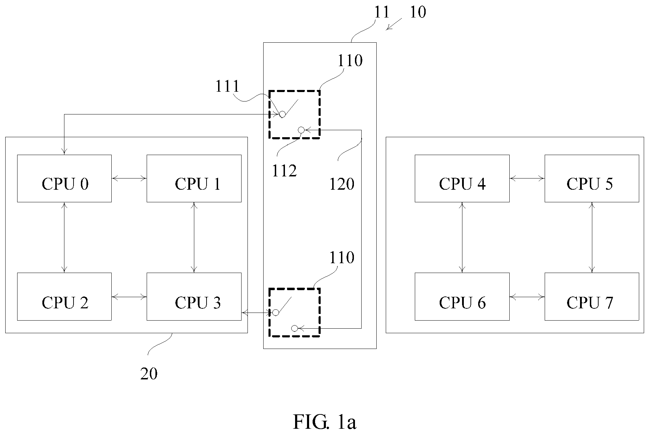

FIG. 1a is a schematic structural diagram of a CPU interconnect apparatus according to an embodiment of the present invention. A CPU interconnect apparatus 10 includes at least one switching circuit 11. Each switching circuit 11 includes two gating units 110 and one first intermediate line 120. Each gating unit 110 includes a first terminal 111 and a second terminal 112. When the gating unit 110 is in a first state, the first terminal 111 is connected to the second terminal 112. When the gating unit 110 is in a second state, the first terminal 111 is disconnected from the second terminal 112. The two first terminals 111 of each switching circuit 11 are respectively configured to connect to two CPUs (for example, a CPU 0 and a CPU 3 in the figure) in a first node 20. The two second terminals 112 of each switching circuit 11 are respectively connected to two ends of the first intermediate line 120.

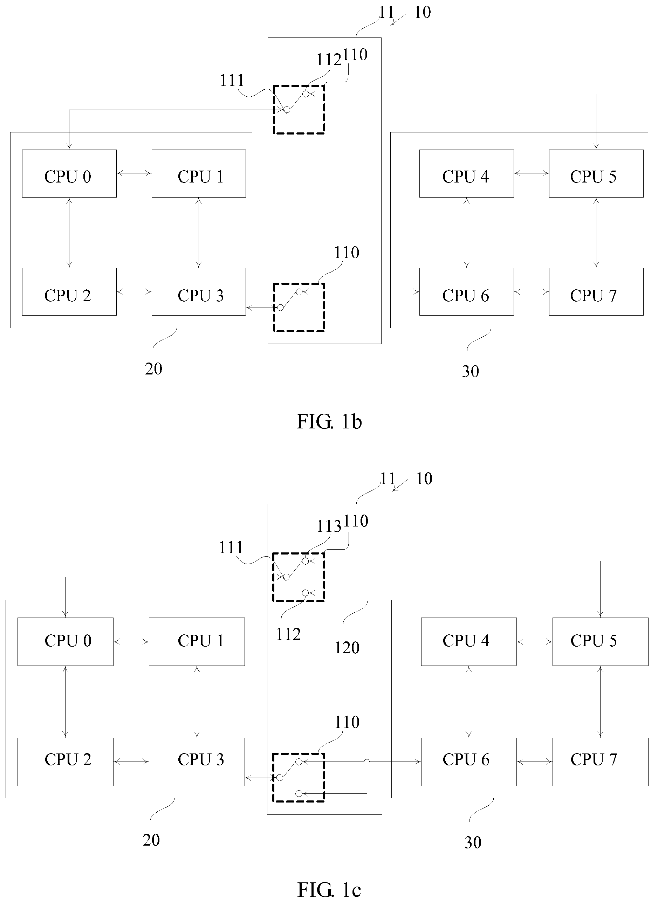

FIG. 1b is a schematic structural diagram of another CPU interconnect apparatus according to an embodiment of the present invention. In comparison with the apparatus provided in FIG. 1a, two second terminals 112 of each switching circuit 11 are respectively configured to connect to two CPUs in a second node.

In this embodiment of the present invention, when two gating units in the CPU interconnect apparatus are in a first state, first terminals are connected to second terminals, and the two second terminals are connected by using a first intermediate line, so that CPU interconnection is implemented in a first node. Alternatively, the two second terminals are respectively configured to connect to two CPUs in a second node, so that CPU interconnection is implemented between the first node and the second node. However, when the two gating units are in a second state, the first terminals are disconnected from the second terminals. Therefore, by switching between the first state and the second state, CPU interconnection and CPU disconnection of intra-node or inter-node can be implemented. Therefore, a topology of a CPU interconnect system meets different feature and scenario requirements, and processing performance of CPUs in the CPU interconnect system is improved.

FIG. 1c is a schematic structural diagram of another CPU interconnect apparatus according to an embodiment of the present invention. In comparison with the apparatus provided in FIG. 1a, a gating unit 110 further includes a third terminal 113. When the gating unit 110 is in a first state, a first terminal 111 is disconnected from the third terminal 113. When the gating unit 110 is in a second state, the first terminal 111 is connected to the third terminal 113. Two second terminals 112 of each switching circuit 11 are respectively connected to two ends of a first intermediate line 120. Two third terminals 113 of each switching circuit 11 are respectively configured to connect to two CPUs in a second node 30.

An embodiment of the present invention further provides another CPU interconnect apparatus. In comparison with the apparatus provided in FIG. 1a, FIG. 1b, or FIG. 1c, the apparatus may further include a second intermediate line, and a third terminal of a switching circuit is connected by using the second intermediate line to a third terminal of a switching circuit to which a CPU in a second node is connected.

An embodiment of the present invention further provides another CPU interconnect apparatus. In comparison with the apparatus provided in FIG. 1a, FIG. 1b, or FIG. 1c, a third terminal of the switching circuit is connected by using a processing unit in a node controller (English: Node Controller, NC for short) to a third terminal of a switching circuit to which a CPU in a second node is connected.

An embodiment of the present invention further provides another CPU interconnect apparatus. In comparison with the apparatus provided in FIG. 1a, FIG. 1b, or FIG. 1c, a gating unit is a switch circuit, an electronic switch, a gate, a selector, an allocator, or hardware logic having a similar function. The gating unit may further be a combination of at least two of the foregoing components. The switch circuit may be implemented by using a hardware chip, a circuit component, a combinatorial circuit, or a logical circuit that has a path selection function (for example, implemented by using an existing circuit in an NC). The specific implementation or combination manners are not limited in the present invention, but all such implementation manners fall within the scope of the present invention.

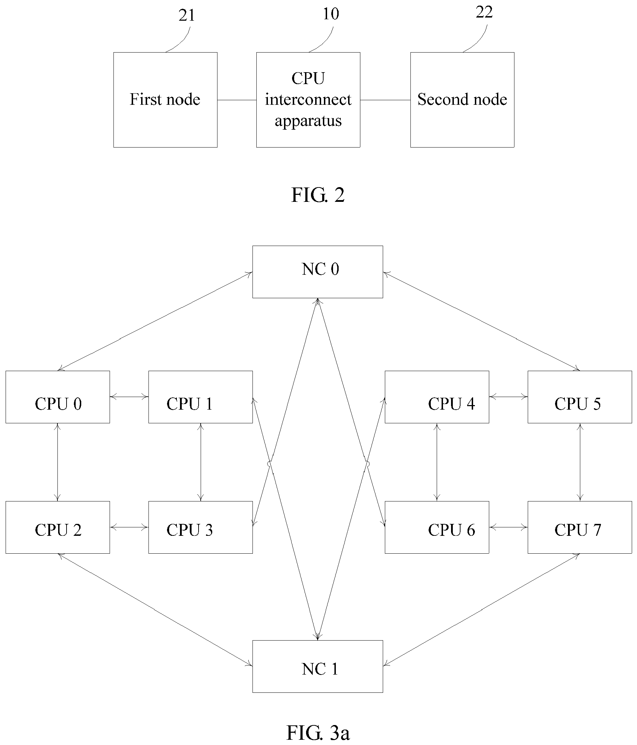

FIG. 2 is a schematic structural diagram of a CPU interconnect system according to an embodiment of the present invention. The system includes multiple nodes. The multiple nodes include a first node 21 and a second node 22, and each node 20 includes multiple directly-connected CPUs. The CPU interconnect system further includes the CPU interconnect apparatus 10 shown in FIG. 1a, FIG. 1b, or FIG. 1c (FIG. 1c is used as an example).

In this embodiment of the present invention, when two gating units in a CPU interconnect apparatus in the CPU interconnect system are in a first state, first terminals are connected to second terminals, and the two second terminals are connected by using a first intermediate line, so that CPU interconnection is implemented in a first node. Alternatively, the two second terminals are respectively configured to connect to two CPUs in a second node, so that CPU interconnection is implemented between the first node and the second node. However, when the two gating units are in a second state, the first terminals are disconnected from the second terminals. Therefore, by switching between the first state and the second state, CPU interconnection and CPU disconnection of intra-node or inter-node can be implemented. Therefore, a topology of the CPU interconnect system meets different feature and scenario requirements, and processing performance of CPUs in the CPU interconnect system is improved.

An embodiment of the present invention further provides another CPU interconnect system. In comparison with the CPU interconnect system provided in FIG. 2, each node in the system includes an even quantity of CPUs, a quantity of gating units in the CPU interconnect system is equal to a quantity of CPUs, each CPU is connected to a first terminal of a gating unit, and the CPUs are connected to different gating units. Certainly, in this embodiment of the present invention, the quantity of gating units included in the CPU interconnect system may also be smaller than the quantity of CPUs.

The following uses an example to describe a CPU interconnect system provided in an embodiment of the present invention.

FIG. 3a is a schematic structural diagram of a CPU interconnect system according to an embodiment of the present invention. Referring to FIG. 3a, the system includes two nodes and two NC 0s. A first node includes CPUs 0 to 3, and the CPU 0, the CPU 1, the CPU 3, and the CPU 2 are connected in a head-to-tail manner to form a ring. Likewise, a second node includes CPUs 4 to 7, and the CPU 4, the CPU 5, the CPU 7, and the CPU 6 are connected in a head-to-tail manner to form a ring. An NC 0 is separately connected to the CPU 0, the CPU 3, the CPU 6, and the CPU 5. An NC 2 is separately connected to the CPU 2, the CPU 1, the CPU 4, and the CPU 7. The foregoing CPUs and the NCs form an 8P partition.

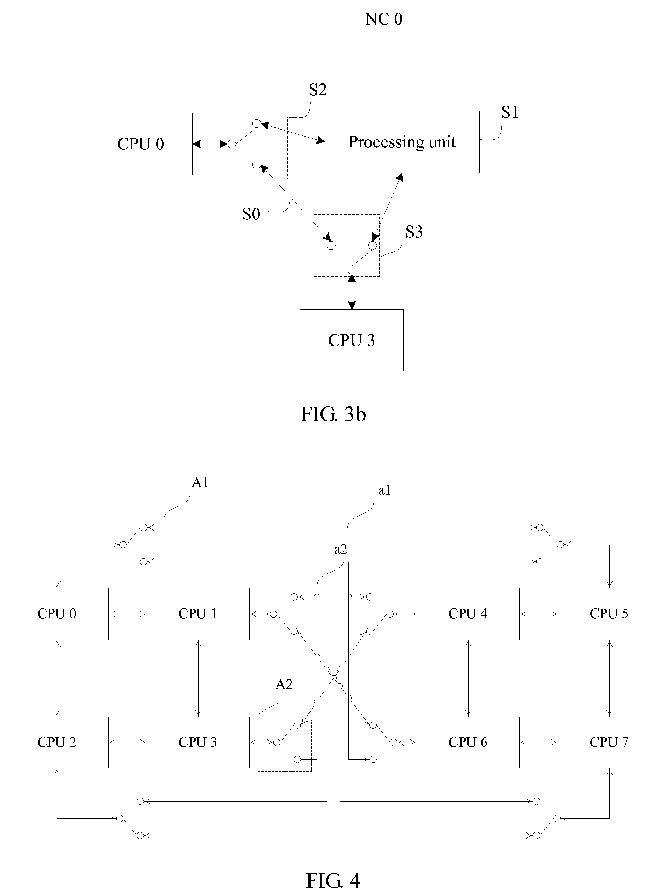

Specifically, the following describes an internal structure of an NC. The NC 0 is used as an example. Specifically, as shown in FIG. 3b, the NC 0 includes a processing unit S1, and the processing unit S1 is configured to perform processing such as data receiving, data verification, data parsing, or data routing, and can implement CPU connection and CPU disconnection. The NC 0 further includes a CPU interconnect apparatus. The CPU interconnect apparatus includes a switching circuit. The switching circuit includes gating units S2 and S3 and a first intermediate line S0. The gating units S2 and S3 are configured to connect the CPU 0 to the CPU 3 by using the processing unit S1 or by using the first intermediate line S0. The first intermediate line S0 is a line in the NC.

FIG. 4 is a schematic structural diagram of another CPU interconnect system according to an embodiment of the present invention. Referring to FIG. 4, the system includes two nodes and a CPU interconnect apparatus. A first node includes CPUs 0 to 3, and the CPU 0, the CPU 1, the CPU 3, and the CPU 2 are connected in a head-to-tail manner to form a ring. Likewise, a second node includes CPUs 4 to 7, and the CPU 4, the CPU 5, the CPU 7, and the CPU 6 are connected in a head-to-tail manner to form a ring. The CPU interconnect apparatus includes a switching circuit. The switching circuit includes gating units A1 and A2 and a first intermediate line a2. The gating units A1 and A2 are respectively configured to connect the CPU 0 to the CPU 3 by using the first intermediate line a2, or connect the CPU 0 to a CPU in the second node by using a second intermediate line (for example, a1).

The line a2 is the second intermediate line. A third terminal of the gating unit A1 in the switching circuit is connected by using the second intermediate line a2 to a third terminal of a switching circuit to which the CPU 5 in the second node is connected.

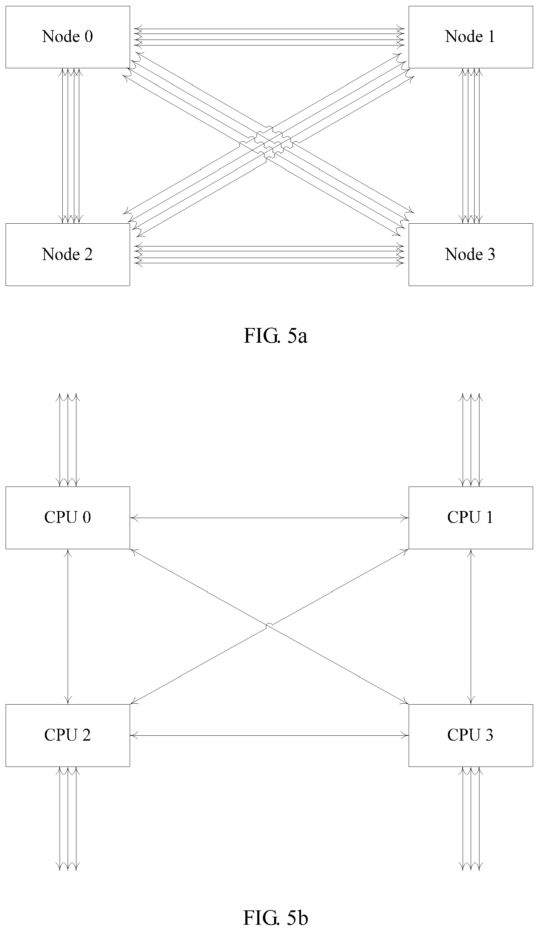

FIG. 5a and FIG. 5b are schematic structural diagrams of another CPU interconnect system according to an embodiment of the present invention. A main difference between this system and the system provided in FIG. 4 lies in that intra-node CPU connection or inter-node CPU connection can be implemented by using multiple lines. Referring to FIG. 5a, the system includes four nodes (nodes 0 to 3), and any two nodes are connected by using four lines. An internal structure of each node is shown in FIG. 5b. The node includes four CPUs (CPUs 0 to 3), there is one path between any two CPUs, and each CPU is connected to the other three nodes by using three lines.

It should be noted that, the quantity of CPUs and the quantity of other components in the foregoing application scenario are only examples, and are not limited in the present invention.

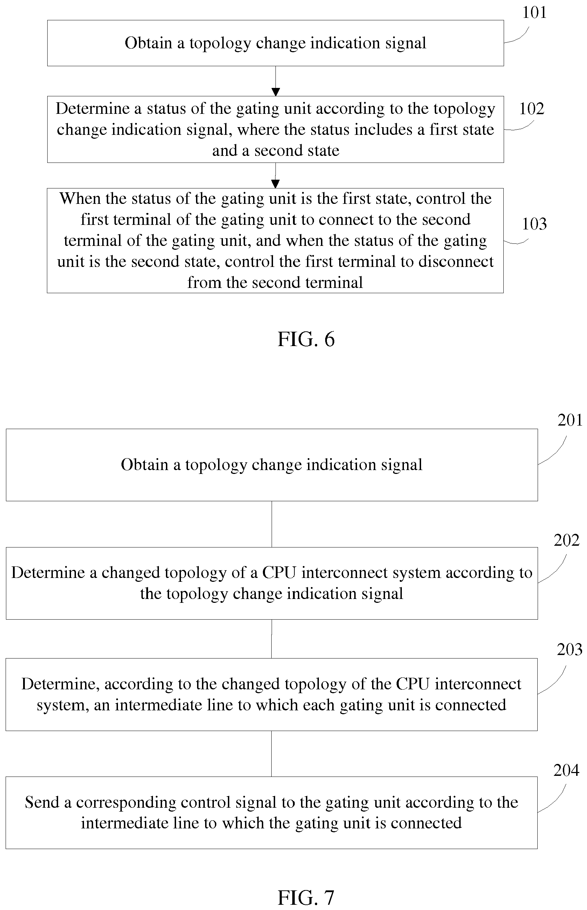

FIG. 6 is a flowchart of a CPU interconnect control method according to an embodiment of the present invention. The method is applicable to the foregoing CPU interconnect system shown in FIG. 2. The CPU interconnect system includes multiple nodes, the multiple nodes include a first node and a second node, and each node includes multiple directly-connected CPUs. The CPU interconnect system further includes a CPU interconnect apparatus. The CPU interconnect apparatus includes at least one switching circuit. Each switching circuit includes two gating units and one first intermediate line. Each gating unit includes a first terminal and a second terminal. The two first terminals of each switching circuit are respectively configured to connect to two CPUs in the first node, and the two second terminals of each switching circuit are respectively connected to two ends of the first intermediate line, or the two second terminals of each switching circuit are respectively configured to connect to two CPUs in the second node. Referring to FIG. 6, the method includes the following steps:
Step 101: Obtain a topology change indication signal.

The topology change indication signal may be entered by a user, or may be automatically generated by the system.

Step 102: Determine a status of the gating unit according to the topology change indication signal, where the status includes a first state and a second state.

Step 103: When the status of the gating unit is the first state, control the first terminal of the gating unit to connect to the second terminal of the gating unit, and when the status of the gating unit is the second state, control the first terminal to disconnect from the second terminal.

In the present invention, a status of a gating unit is determined according to an obtained topology change indication signal. The status includes a first state and a second state. When the status of the gating unit is the first state, a first terminal of the gating unit is controlled to connect to a second terminal of the gating unit, and when the status of the gating unit is the second state, the first terminal is controlled to disconnect from the second terminal. Therefore, a path between CPUs is selected intelligently according to a topology change indication, a topology of a CPU interconnect system meets a current requirement, and processing performance of CPUs in the CPU interconnect system is improved.

FIG. 7 is a flowchart of another CPU interconnect control method according to an embodiment of the present invention. The method is applicable to the foregoing CPU interconnect system. Referring to FIG. 7, the method includes the following steps.

Step 201: Obtain a topology change indication signal, where the topology change indication signal is used to instruct to make a topology change to the CPU interconnect system.

In an implementation manner of this embodiment of the present invention, the obtaining a topology change indication signal includes:
receiving the topology change indication signal entered by a user, where the topology change indication signal includes topology change indication information, and the topology change indication information includes a changed quantity (for example, 4) of CPUs in a system partition or a changed system application scenario. Certainly, the topology change indication information is not limited to the form enumerated above, for example, the topology change indication information may further directly indicate that an intra-node connection or an inter-node connection is preferred.

In another implementation manner of this embodiment of the present invention, the obtaining a topology change indication signal includes:
obtaining system monitoring information, where the system monitoring information includes at least one of CPU load or a CPU latency; and
generating the topology change indication signal according to the system monitoring information, where the topology change indication signal includes topology change indication information, and the topology change indication information includes at least one of a CPU with excessively high load or a CPU with an excessively long latency.

The generating the topology change indication signal according to the system monitoring information may include: Load in the system monitoring information is compared with a preset load threshold and a latency in the system monitoring information is compared with a preset latency threshold; and the topology change indication signal is generated when the load in the system monitoring information is greater than the preset load threshold or the latency is greater than the preset latency threshold. The system monitoring information may be obtained by using an existing performance detection apparatus or circuit. Details are not described herein.

Step 202: Determine a status of a gating unit according to the topology change indication signal, where the status includes a first state and a second state.

Specifically, step 202 may include:
determining a changed topology of the CPU interconnect system according to the topology change indication signal; and
determining the status of the gating unit according to the changed topology of the CPU interconnect system.

In an implementation manner of this embodiment of the present invention, the following manner may be used to determine the changed topology of the CPU interconnect system according to the topology change indication signal:
Step 1: Obtain a correspondence between the topology change indication signal and a topology.

For a system, layout of components such as a CPU is fixed. Therefore, a corresponding topology structure may be designed in advance according to the topology change indication signal. Specifically, the correspondence between the topology change indication signal and a topology includes but is not limited to: a correspondence between a change of a quantity of CPUs in the system partition and a topology, a correspondence between a system application scenario and a topology, a correspondence between excessively high load and a topology, and a correspondence between an excessively long latency and a topology.

The following describes the correspondence between the topology change indication and a topology by using an example.

For example, the correspondence between the change indication of a quantity of CPUs in the system partition and a topology may be set in the following manner.

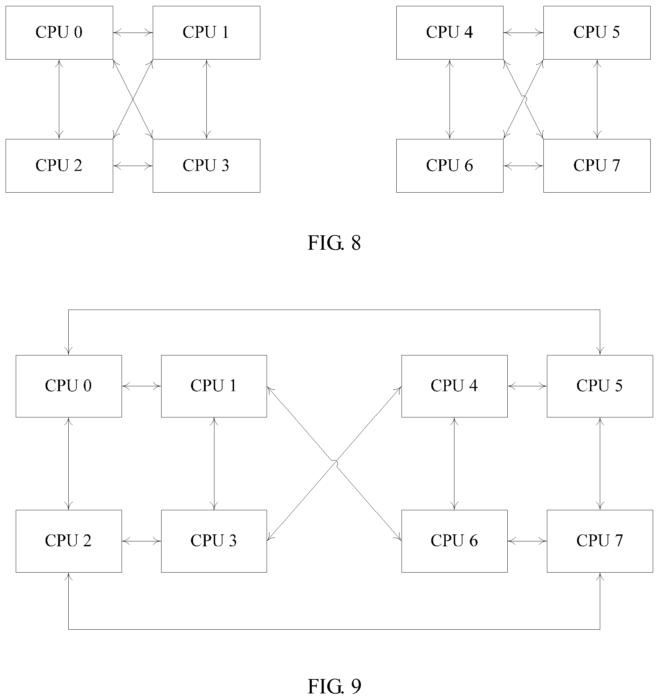

FIG. 3a and FIG. 3b are used as examples. When CPUs (for example, the CPU 0 and the CPU 3) are connected by using the processing unit, an 8P partition is formed, and a topology of the 8P partition is shown in FIG. 3a. When CPUs are connected by using the first intermediate line, two 4P partitions are formed, and a simplified topology of the 4P partitions is shown in FIG. 8. Therefore, the correspondence between the topology change indication and a topology may be as follows: When the quantity of CPUs in the system partition included in the topology change indication information is 8, a topology corresponding to the system partition is shown in FIG. 3a. When the quantity of CPUs in the system partition included in the topology change indication information is 4, a topology corresponding to the system partition is shown in FIG. 8.

FIG. 4 is used as an example. When the quantity of CPUs in the system partition included in the topology change indication information is 8, a topology corresponding to the system partition is shown in FIG. 9. When the quantity of CPUs in the system partition included in the topology change indication information is 4, a topology corresponding to the system partition is shown in FIG. 8.

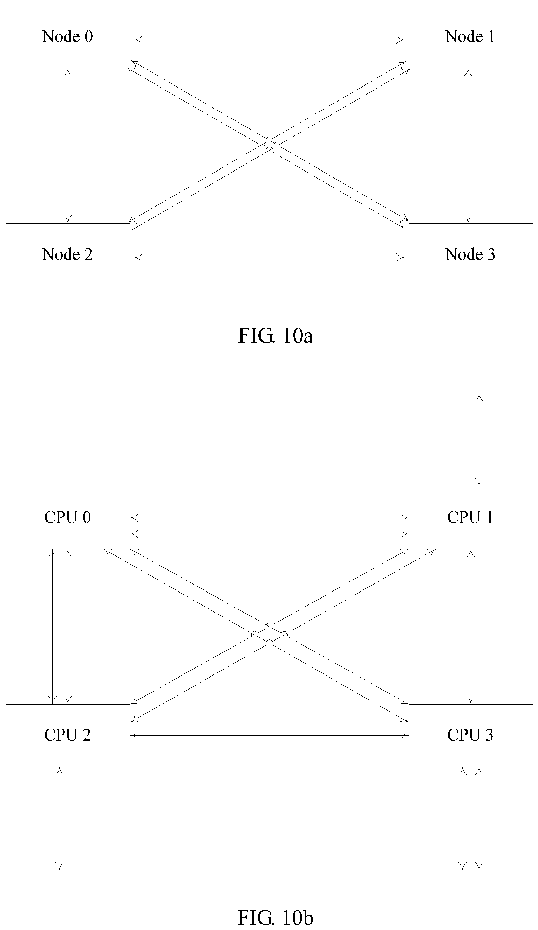

FIG. 5a is used as an example. When the system application scenario included in the topology change indication information is an online analytical processing OLAP scenario, a topology corresponding to the system application scenario is shown in FIG. 5a and FIG. 5b. When the system application scenario included in the topology change indication information is an online transaction processing OLTP scenario, a topology corresponding to the system application scenario is shown in FIG. 10a and FIG. 10b.

Step 2: Determine the changed topology of the CPU interconnect system according to the correspondence between the topology change indication signal and a topology, where the changed topology of the CPU interconnect system corresponds to the topology change indication signal.

In another implementation manner of this embodiment of the present invention, the following manner may be used to determine the changed topology of the CPU interconnect system according to the topology change indication signal:
Step 1: Determine a topology change according to the topology change indication signal, where the topology change includes that a line between two CPUs is connected or that a line between two CPUs is disconnected.

Step 1 may include: when the topology change indication signal includes a CPU with excessively high load or a CPU with an excessively long latency, determining the CPU with excessively high load or with an excessively long latency; and changing a connection between the determined CPU and a CPU in a second node to a connection between CPUs in a first node, where the determined CPU is located in the first node.

Step 2: Determine the changed topology of the CPU interconnect system according to the topology change and a topology that is of the CPU interconnect system and is before a change.

The topology that is of the CPU interconnect system and is before a change may be obtained before step 201, or may be obtained before step 1. Therefore, in this implementation manner, step 202 may further include: obtaining the topology that is of the CPU interconnect system and is before a change.

The following describes the topology change by using an example.

FIG. 3a is used as an example. The topology before a change is shown in FIG. 3a. When the topology change indication signal includes an excessively long latency, and CPUs with an excessively long latency are the CPU 0 and the CPU 1 in the first node, a latency of the CPU 0 and that of the CPU 1 in the first node need to be reduced. Specifically, the two latencies may be reduced by adding a connection line between the CPU 0 and CPU 3 and between the CPU 1 and the CPU 2 in this node. The changed topology determined according to this solution is shown in FIG. 8.

FIG. 4 is used as an example. The topology before a change is shown in FIG. 9. When the topology change indication signal includes an excessively long latency, and CPUs with an excessively long latency are the CPU 0 and the CPU 1 in the first node, a latency of the CPU 0 and that of the CPU 1 in the first node need to be reduced. Specifically, the two latencies may be reduced by adding a connection line between the CPU 0 and CPU 3 and between the CPU 1 and the CPU 2 in this node. The changed topology determined according to this solution is shown in FIG. 8.

FIG. 5a is used as an example. The topology before a change is shown in FIG. 5a and FIG. 5b. When the topology change indication signal includes excessively high load, and CPUs with excessively high load are the CPU 0 and the CPU 1 in the first node, load of the CPU 0 and that of the CPU 1 in the first node need to be reduced. Specifically, the load of the CPUs may be reduced by adding connection lines between the CPU 0 and other CPUs in this node. For example, a quantity of lines between the CPU 0 and any other CPU in this node is increased to two. The changed topology determined according to this solution is shown in FIG. 10a and FIG. 10b.

In the foregoing solution, the topology is indicated by using a diagram. However, for a processor or a controller, to reduce processing complexity of the processor or the controller, the topology may be indicated in the following connection set manner. Specifically, in the foregoing two implementation manners, the determining a changed topology of the CPU interconnect system includes:
determining connection sets C1, C2, and C3, where the connection set C1 includes a direct connection between two CPUs, the connection set C2 includes a first intermediate line, a second intermediate line, and a connection between a CPU and a gating unit or a connection between a CPU and a processing unit, and the connection set C3 includes a pseudo-direct connection, where the pseudo-direct connection is a connection established between two CPUs by using the first intermediate line or the second intermediate line.

Specifically, the connection set C1 is a direct connection between two CPUs, and may be indicated by using two CPUs, for example, (CPU 0 and CPU 1). For a multi-node system, a node number may be added before a CPU, for example, (node 1 CPU 0 and node 2 CPU 1). The connection set C2 includes a first or second intermediate line, and a connection between a CPU and a gating unit, or a connection between a CPU and a node connector, and may be indicated by using gating units at two ends of the first or second intermediate line or may be indicated by using CPUs and gating units at two ends of the line, for example, (A1 and A2), or (CPU 0 and A1). Likewise, for a multi-node system, a node number may be added before a CPU and a gating unit. The connection set C3 includes a pseudo-direct connection, and may be indicated by using two CPUs connected by the pseudo-direct connection and two intermediate gating units, for example, (CPU 0, A1, A2, and CPU 1). Likewise, for a multi-node system, a node number may be added before a CPU and a gating unit. In this embodiment of the present invention, the pseudo-direct connection only requires signal or data forwarding at a hardware layer or a physical layer, and does not require data processing at layer 2 or above, such as data receiving, data verification, data parsing, data switching, data reconstitution, or data routing.

In the foregoing step, the determining the changed topology of the CPU interconnect system includes determining the connection sets C1, C2, and C3.

In this embodiment of the present invention, the determining the status of the gating unit according to the changed topology of the CPU interconnect system includes:
obtaining the connection sets C2 and C3 in the changed topology of the CPU interconnect system;
determining, according to the connection sets C2 and C3, a first intermediate line or a second intermediate line to which each gating unit is connected; and
determining the status of the gating according to the first intermediate line or the second intermediate line to which each gating unit is connected.

FIG. 3a is used as an example. When the gating unit is connected to the first intermediate line S0, it is determined that the gating unit is in the first state.

Step 203: When the status of the gating unit is the first state, control a first terminal of the gating unit to connect to a second terminal of the gating unit, and control the first terminal to disconnect from a third terminal; when the status of the gating unit is the second state, control the first terminal to disconnect from the second terminal, and control the first terminal connect to the third terminal.

The gating unit further includes the third terminal. Two second terminals of each switching circuit are respectively connected to two ends of the first intermediate line, and two third terminals of each switching circuit are respectively configured to connect to two CPUs in the second node.

In specific control, a corresponding control signal is determined according to the status of the gating unit, and the determined control signal is sent to the gating unit.

Specifically, the control signal may include a binary number 0 or 1. In this embodiment of the present invention, the control signal may be a single signal such as 0 or 1, or may be a combination of multiple signals. In addition, the control signal may also be a signal obtained after an operation (for example, a NOT operation) is performed on a single signal or a combination.

The CPU interconnect control method provided in the present invention is mainly applied to various scenarios in which a CPU connection needs to be adjusted. An adjustment of a CPU interconnect topology greatly improves CPU interconnect performance. For example, when a CPU has a long latency or high load, an inter-node CPU connection is added, and a hop count of data transmission between inter-node CPUs is reduced. Therefore, an amount of transmitted data is reduced, and processing performance of the CPUs is improved to a great extent.

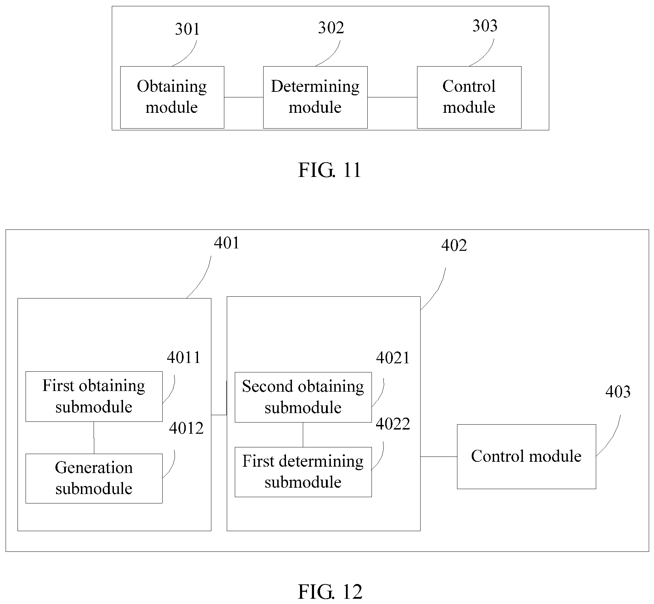

FIG. 11 is a schematic structural diagram of a CPU interconnect control apparatus according to an embodiment of the present invention. The apparatus is applicable to the foregoing CPU interconnect system shown in FIG. 2. The CPU interconnect system includes multiple nodes, the multiple nodes include a first node and a second node, and each node includes multiple directly-connected CPUs. The CPU interconnect system further includes a CPU interconnect apparatus. The CPU interconnect apparatus includes at least one switching circuit. Each switching circuit includes two gating units and one first intermediate line. Each gating unit includes a first terminal and a second terminal. The two first terminals of each switching circuit are respectively configured to connect to two CPUs in the first node, and the two second terminals of each switching circuit are respectively connected to two ends of the first intermediate line, or the two second terminals of each switching circuit are respectively configured to connect to two CPUs in the second node. Referring to FIG. 11, the apparatus includes:
an obtaining module 301, configured to obtain a topology change indication signal;
a determining module 302, configured to determine a status of the gating unit according to the topology change indication signal, where the status includes a first state and a second state; and
a control module 303, configured to: when the status of the gating unit is the first state, control the first terminal of the gating unit to connect to the second terminal of the gating unit, and when the status of the gating unit is the second state, control the first terminal to disconnect from the second terminal.

In the present invention, a status of a gating unit is determined according to an obtained topology change indication signal. The status includes a first state and a second state. When the status of the gating unit is the first state, a first terminal of the gating unit is controlled to connect to a second terminal of the gating unit, and when the status of the gating unit is the second state, the first terminal is controlled to disconnect from the second terminal. Therefore, a path between CPUs is selected intelligently according to a topology change indication, a topology of a CPU interconnect system meets a current requirement, and processing performance of CPUs in the CPU interconnect system is improved.

FIG. 12 is a schematic structural diagram of a CPU interconnect control apparatus according to an embodiment of the present invention. The apparatus is applicable to the foregoing CPU interconnect system. Referring to FIG. 12, the apparatus includes:
an obtaining module 401, configured to obtain a topology change indication signal;
a determining module 402, configured to determine a status of a gating unit according to the topology change indication signal, where the status includes a first state and a second state; and
a control module 403, configured to: when the status of the gating unit is the first state, control a first terminal of the gating unit to connect to a second terminal of the gating unit, and when the status of the gating unit is the second state, control the first terminal to disconnect from the second terminal.

Further, the gating unit further includes a third terminal. Two second terminals of each switching circuit are respectively connected to two ends of a first intermediate line, and two third terminals of each switching circuit are respectively configured to connect to two CPUs in a second node. The control module 403 is further configured to:
when the status of the gating unit is the first state, control the first terminal to disconnect from the third terminal, and when the status of the gating unit is the second state, control the first terminal to connect to the third terminal.

In an implementation manner, the obtaining module 401 is specifically configured to:
receive the topology change indication signal entered by a user, where the topology change indication signal includes topology change indication information, and the topology change indication information includes a changed quantity of CPUs in a system partition or a changed system application scenario.

In another implementation manner, the obtaining module 401 includes:
a first obtaining submodule 4011, configured to obtain system monitoring information, where the system monitoring information includes at least one of CPU load or a CPU latency; and
a generation submodule 4012, configured to generate the topology change indication signal according to the system monitoring information, where the topology change indication signal includes topology change indication information, and the topology change indication information includes at least one of a CPU with excessively high load or a CPU with excessively long latency.

In an implementation manner of this embodiment of the present invention, the determining module 402 includes:
a second obtaining submodule 4021, configured to determine a changed topology of the CPU interconnect system according to the topology change indication signal; and
a first determining submodule 4022, configured to determine the status of the gating unit according to the changed topology of the CPU interconnect system.

In an implementation manner of this embodiment of the present invention, the second obtaining submodule 4021 is specifically configured to:
obtain a correspondence between the topology change indication signal and a topology; and
determine the changed topology of the CPU interconnect system according to the correspondence between the topology change indication signal and a topology, where the changed topology of the CPU interconnect system corresponds to the topology change indication signal.

In another implementation manner of this embodiment of the present invention, the second obtaining submodule 4021 is specifically configured to:
determine a topology change according to the topology change indication signal, where the topology change includes that a line between two CPUs is connected or that a line between two CPUs is disconnected; and
determine the changed topology of the CPU interconnect system according to the topology change and a topology that is of the CPU interconnect system and is before a change.

The topology that is of the CPU interconnect system and is before a change may be obtained in advance, or may be obtained by the determining module 402. Therefore, in this implementation manner, the determining module 402 may further include the second obtaining submodule 4021, configured to obtain the topology that is of the CPU interconnect system and is before a change.

Specifically, the second obtaining submodule 4021 is specifically configured to:
when the topology change indication signal includes a CPU with excessively high load or a CPU with an excessively long latency, determine the CPU with excessively high load or with an excessively long latency; and
change a connection between the determined CPU and a CPU in the second node to a connection between CPUs in a first node, where the determined CPU is located in the first node.

In this embodiment of the present invention, the second obtaining submodule 4021 is specifically configured to:
determine connection sets C1, C2, and C3, where the connection set C 1 includes a direct connection between two CPUs, the connection set C2 includes a first intermediate line, a second intermediate line, and a connection between a CPU and a gating unit or a connection between a CPU and a processing unit, and the connection set C3 includes a pseudo-direct connection, where the pseudo-direct connection is a connection established between two CPUs by using the first intermediate line or the second intermediate line.

Further, the first determining submodule 4022 is specifically configured to:
obtain the connection sets C2 and C3 in the changed topology of the CPU interconnect system;
determine, according to the connection sets C2 and C3, a first intermediate line or a second intermediate line to which each gating unit is connected; and
determine the status of the gating according to the first intermediate line or the second intermediate line to which each gating unit is connected.

For the apparatus in the foregoing embodiment, specific manners of executing operations by modules are described in detail in the embodiments related to the method, and details are not described herein again.

It should be noted that, when CPUs are interconnected by the CPU interconnect control apparatus provided in the foregoing embodiment, only division of the foregoing function modules is used as an example for description. In actual application, the foregoing functions can be allocated to different modules for completion according to a requirement, that is, an inner structure of a device is divided into different function modules to complete all or some of the functions described above. In addition, the embodiments of the CPU interconnect control apparatus and the CPU interconnect control method provided in the foregoing embodiments belong to a same conception. For a specific implementation process thereof, refer to the method embodiment. Details are not described herein again.

A person of ordinary skill in the art may understand that all or some of the steps of the embodiments may be implemented by hardware or a program instructing related hardware. The program may be stored in a computer-readable storage medium. The storage medium may be a read-only memory, a magnetic disk, or an optical disc.

The foregoing descriptions are merely examples of embodiments of the present invention, but are not intended to limit the present invention. Any modification, equivalent replacement, and improvement made without departing from the spirit and principle of the present invention shall fall within the protection scope of the present invention.

## Claims

1. A CPU interconnect apparatus, comprising at least one switching circuit, wherein each switching circuit comprises two gating units and one first intermediate line, each gating unit comprises a first terminal and a second terminal, the first terminal is connected to the second terminal when the gating unit is in a first state, the first terminal is disconnected from the second terminal when the gating unit is in a second state, the two first terminals of each switching circuit are respectively configured to connect to two CPUs in a first node, and the two second terminals of each switching circuit are respectively connected to two ends of the first intermediate line, or two second terminals of each switching circuit are respectively configured to connect to two CPUs in a second node.

2. The apparatus according to claim 1, wherein the gating unit further comprises a third terminal, the first terminal is disconnected from the third terminal when the gating unit is in the first state, the first terminal is connected to the third terminal when the gating unit is in the second state, the two second terminals of each switching circuit are respectively connected to the two ends of the first intermediate line, and the two third terminals of each switching circuit are respectively configured to connect to two CPUs in the second node.

3. The apparatus according to claim 2, wherein the apparatus comprises a second intermediate line, and a third terminal of the switching circuit is connected by using the second intermediate line to a third terminal of a switching circuit to which a CPU in the second node is connected.

4. The apparatus according to claim 2, wherein a third terminal of the switching circuit is connected by using a processing unit in an NC to a third terminal of a switching circuit to which a CPU in the second node is connected.

5. The apparatus according to claim 2, wherein the gating unit is a switch circuit, an electronic switch, a gate, a selector, or an allocator.

6. A CPU interconnect system, comprising multiple nodes, wherein the multiple nodes comprise a first node and a second node, and each node comprises multiple directly-connected CPUs, wherein the CPU interconnect system further comprises the CPU interconnect apparatus according to any one of claims 1 to 5.

7. A CPU interconnect control method, applicable to a CPU interconnect system, wherein the CPU interconnect system comprises multiple nodes, the multiple nodes comprise a first node and a second node, and each node comprises multiple directly-connected CPUs, wherein the CPU interconnect system further comprises a CPU interconnect apparatus, the CPU interconnect apparatus comprises at least one switching circuit, each switching circuit comprises two gating units and one first intermediate line, each gating unit comprises a first terminal and a second terminal, the two first terminals of each switching circuit are respectively configured to connect to two CPUs in the first node, and the two second terminals of each switching circuit are respectively connected to two ends of the first intermediate line, or the two second terminals of each switching circuit are respectively configured to connect to two CPUs in the second node, and the method comprises:
obtaining a topology change indication signal;
determining a status of the gating unit according to the topology change indication signal, wherein the status comprises a first state and a second state; and
when the status of the gating unit is the first state, controlling the first terminal of the gating unit to connect to the second terminal of the gating unit, and when the status of the gating unit is the second state, controlling the first terminal to disconnect from the second terminal.

8. The method according to claim 7, wherein the gating unit further comprises a third terminal, the two second terminals of each switching circuit are respectively connected to the two ends of the first intermediate line, the two third terminals of each switching circuit are respectively configured to connect to two CPUs in the second node, and the method further comprises:
when the status of the gating unit is the first state, controlling the first terminal to disconnect from the third terminal, and when the status of the gating unit is the second state, controlling the first terminal to connect to the third terminal.

9. The method according to claim 7 or 8, wherein the obtaining a topology change indication signal comprises:
receiving the topology change indication signal entered by a user, wherein the topology change indication signal comprises the topology change indication information, the topology change indication information comprises a changed quantity of CPUs in a system partition or a changed system application scenario, and the system application scenario is an online analytical processing scenario or an online transaction processing scenario.

10. The method according to claim 7 or 8, wherein the obtaining a topology change indication signal comprises:
obtaining system monitoring information, wherein the system monitoring information comprises at least one of CPU load or a CPU latency; and
generating the topology change indication signal according to the system monitoring information, wherein the topology change indication signal comprises topology change indication information, and the topology change indication information comprises at least one of a CPU with excessively high load or a CPU with an excessively long latency.

11. The method according to claim 7 or 8, wherein the determining a status of the gating unit according to the topology change indication signal comprises:
determining a changed topology of the CPU interconnect system according to the topology change indication signal; and
determining the status of the gating unit according to the changed topology of the CPU interconnect system.

12. The method according to claim 11, wherein the determining a changed topology of the CPU interconnect system according to the topology change indication signal comprises:
obtaining a correspondence between the topology change indication signal and a topology; and
determining the changed topology of the CPU interconnect system according to the correspondence between the topology change indication signal and a topology, wherein the changed topology of the CPU interconnect system corresponds to the topology change indication signal.

13. The method according to claim 11, wherein the determining a changed topology of the CPU interconnect system according to the topology change indication signal comprises:
determining a topology change according to the topology change indication signal, wherein the topology change comprises that a line between two CPUs is connected or that a line between two CPUs is disconnected; and
determining the changed topology of the CPU interconnect system according to the topology change and a topology that is of the CPU interconnect system and is before a change.

14. The method according to claim 13, wherein the determining a topology change according to the topology change indication signal comprises:
when the topology change indication signal comprises a CPU with excessively high load or a CPU with an excessively long latency, determining the CPU with excessively high load or with an excessively long latency; and
changing a connection between the determined CPU and a CPU in the second node to a connection between CPUs in the first node, wherein the determined CPU is located in the first node.

15. The method according to any one of claims 12 to 14, wherein the determining a changed topology of the CPU interconnect system comprises:
determining connection sets C1, C2, and C3, wherein the connection set C1 comprises a direct connection between two CPUs, the connection set C2 comprises a first intermediate line, a second intermediate line, and a connection between a CPU and a gating unit or a connection between a CPU and a processing unit, and the connection set C3 comprises a pseudo-direct connection, wherein the pseudo-direct connection is a connection established between two CPUs by using the first intermediate line or the second intermediate line.

16. The method according to claim 15, wherein the determining the status of the gating unit according to the changed topology of the CPU interconnect system comprises:
obtaining the connection sets C2 and C3 in the changed topology of the CPU interconnect system;
determining, according to the connection sets C2 and C3, a first intermediate line or a second intermediate line to which each gating unit is connected; and
determining the status of the gating according to the first intermediate line or the second intermediate line to which each gating unit is connected.

17. A CPU interconnect control apparatus, applicable to a CPU interconnect system, wherein the CPU interconnect system comprises multiple nodes, the multiple nodes comprise a first node and a second node, and each node comprises multiple directly-connected CPUs, wherein the CPU interconnect system further comprises a CPU interconnect apparatus, the CPU interconnect apparatus comprises at least one switching circuit, each switching circuit comprises two gating units and one first intermediate line, each gating unit comprises a first terminal and a second terminal, the two first terminals of each switching circuit are respectively configured to connect to two CPUs in the first node, and the two second terminals of each switching circuit are respectively connected to two ends of the first intermediate line, or the two second terminals of each switching circuit are respectively configured to connect to two CPUs in the second node, and the apparatus comprises:
an obtaining module, configured to obtain a topology change indication signal;
a determining module, configured to determine a status of the gating unit according to the topology change indication signal, wherein the status comprises a first state and a second state; and
a control module, configured to: when the status of the gating unit is the first state, control the first terminal of the gating unit to connect to the second terminal of the gating unit, and when the status of the gating unit is the second state, control the first terminal to disconnect from the second terminal.

18. The apparatus according to claim 17, wherein the gating unit further comprises a third terminal, the two second terminals of each switching circuit are respectively connected to the two ends of the first intermediate line, the two third terminals of each switching circuit are respectively configured to connect to two CPUs in the second node, and the control module is further configured to:
when the status of the gating unit is the first state, control the first terminal to disconnect from the third terminal, and when the status of the gating unit is the second state, control the first terminal to connect to the third terminal.

19. The apparatus according to claim 17 or 18, wherein the obtaining module is specifically configured to:
receive the topology change indication signal entered by a user, wherein the topology change indication signal comprises the topology change indication information, the topology change indication information comprises a changed quantity of CPUs in a system partition or a changed system application scenario, and the system application scenario is an online analytical processing scenario or an online transaction processing scenario.

20. The apparatus according to claim 17 or 18, wherein the obtaining module comprises:
a first obtaining submodule, configured to obtain system monitoring information, wherein the system monitoring information comprises at least one of CPU load or a CPU latency; and
a generation submodule, configured to generate the topology change indication signal according to the system monitoring information, wherein the topology change indication signal comprises topology change indication information, and the topology change indication information comprises at least one of a CPU with excessively high load or a CPU with an excessively long latency.

21. The apparatus according to claim 17 or 18, wherein the determining module comprises:
a second obtaining submodule, configured to determine a changed topology of the CPU interconnect system according to the topology change indication signal; and
a first determining submodule, configured to determine the status of the gating unit according to the changed topology of the CPU interconnect system.

22. The apparatus according to claim 21, wherein the second obtaining submodule is specifically configured to:
obtain a correspondence between the topology change indication signal and a topology; and
determine the changed topology of the CPU interconnect system according to the correspondence between the topology change indication signal and a topology, wherein the changed topology of the CPU interconnect system corresponds to the topology change indication signal.

23. The apparatus according to claim 21, wherein the second obtaining submodule is specifically configured to:
determine a topology change according to the topology change indication signal, wherein the topology change comprises that a line between two CPUs is connected or that a line between two CPUs is disconnected; and
determine the changed topology of the CPU interconnect system according to the topology change and a topology that is of the CPU interconnect system and is before a change.

24. The apparatus according to claim 23, wherein the second obtaining submodule is specifically configured to:
when the topology change indication signal comprises a CPU with excessively high load or a CPU with an excessively long latency, determine the CPU with excessively high load or with an excessively long latency; and
change a connection between the determined CPU and a CPU in the second node to a connection between CPUs in the first node, wherein the determined CPU is located in the first node.

25. The apparatus according to any one of claims 22 to 24, wherein the second obtaining submodule is specifically configured to:
determine connection sets C1, C2, and C3, wherein the connection set C1 comprises a direct connection between two CPUs, the connection set C2 comprises a first intermediate line, a second intermediate line, and a connection between a CPU and a gating unit or a connection between a CPU and a processing unit, and the connection set C3 comprises a pseudo-direct connection, wherein the pseudo-direct connection is a connection established between two CPUs by using the first intermediate line or the second intermediate line.

26. The apparatus according to claim 25, wherein the first determining submodule is specifically configured to:
obtain the connection sets C2 and C3 in the changed topology of the CPU interconnect system;
determine, according to the connection sets C2 and C3, a first intermediate line or a second intermediate line to which each gating unit is connected; and
determine the status of the gating according to the first intermediate line or the second intermediate line to which each gating unit is connected.
